(19) Europäisches Patentamt
European Patent Office
Office européen des brevets

(11) **EP 3 641 518 A1**

(12) **EUROPEAN PATENT APPLICATION**
published in accordance with Art. 153(4) EPC

(43) Date of publication:
**22.04.2020 Bulletin 2020/17**

(51) Int Cl.:
*H05K 9/00* (2006.01)  *B32B 7/02* (2019.01)
*B32B 9/00* (2006.01)  *B32B 15/08* (2006.01)

(21) Application number: **18818295.0**

(22) Date of filing: **27.03.2018**

(86) International application number:
**PCT/JP2018/012604**

(87) International publication number:
**WO 2018/230094 (20.12.2018 Gazette 2018/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.06.2017 JP 2017116299**

(71) Applicant: **Nitto Denko Corporation**
**Ibaraki-shi, Osaka 567-8680 (JP)**

(72) Inventors:
• **YAMAGATA Kazuto**
**Ibaraki-shi**
**Osaka 567-8680 (JP)**
• **MACHINAGA Hironobu**
**Ibaraki-shi**
**Osaka 567-8680 (JP)**

• **TAKEDA Yuuki**
**Ibaraki-shi**
**Osaka 567-8680 (JP)**
• **UEDA Eri**
**Ibaraki-shi**
**Osaka 567-8680 (JP)**
• **UKEI Hiroichi**
**Ibaraki-shi**
**Osaka 567-8680 (JP)**
• **UI Takehiro**
**Ibaraki-shi**
**Osaka 567-8680 (JP)**

(74) Representative: **Grünecker Patent- und**
**Rechtsanwälte**
**PartG mbB**
**Leopoldstraße 4**
**80802 München (DE)**

(54) **ELECTROMAGNETIC-WAVE ABSORBER AND MOLDED ARTICLE PROVIDED WITH ELECTROMAGNETIC-WAVE ABSORBER**

(57)     An electromagnetic wave absorber (1) includes a dielectric layer (10), a resistive layer (20), and an electrical conductive layer (30). The resistive layer (20) is disposed on one principal surface of the dielectric layer (10). The electrical conductive layer (30) is disposed on the other principal surface of the dielectric layer (10) and has a sheet resistance lower than a sheet resistance of the resistive layer (20). The resistive layer (20) includes indium oxide as a main component, has a polycrystalline structure, and has a sheet resistance of 260 to 500 $\Omega/\square$ and a specific resistance of $5 \times 10^{-4}$ $\Omega \cdot$ cm or more.

FIG.1

**Description**

TECHNICAL FIELD

The present invention relates to an electromagnetic wave absorber and an electromagnetic wave absorber-attached molded article.

BACKGROUND ART

In recent years, electromagnetic waves in a range of millimeter waves having a wavelength of about 1 to 10 mm and a frequency of 30 to 300 GHz and quasi-millimeter waves have been used as information communication media. The use of such electromagnetic waves in anti-collision systems has been under consideration. An anti-collision system is a system, for example, installed in a vehicle, detecting obstacles to automatically put on the brakes, or measuring the speed of vehicles around the vehicle equipped with the system and distance between the vehicle and another vehicle to adjust the speed of the vehicle and distance between the two vehicles. To allow anti-collision systems to normally operate, reception of as few unnecessary electromagnetic waves as possible is important for prevention of false recognition. Therefore, it is conceivable to use an electromagnetic wave absorber in anti-collision systems to absorb unnecessary electromagnetic waves.

There are various types of electromagnetic wave absorbers classified according to their principles of electromagnetic wave absorption. For example, an electromagnetic wave absorber provided with an electromagnetic wave reflective layer, a dielectric layer having a thickness of $\lambda/4$ ($\lambda$ is a wavelength of an electromagnetic wave to be absorbed), and a resistive film layer (such an electromagnetic wave absorber may be referred to as "$\lambda/4$ electromagnetic wave absorber") can be produced at a low cost owing to relatively inexpensive materials and ease of design. For example, Patent Literature 1 proposes, as a $\lambda/4$ electromagnetic wave absorber, an electromagnetic wave absorber exercising its function in a wide incident angular range.

CITATION LIST

Patent Literature

Patent Literature 1: JP 2003-198179 A

SUMMARY OF INVENTION

Technical Problem

Patent Literature 1 fails to specifically discuss the durability (for example, chemical resistance) typically required in environments where electromagnetic wave absorbers are used.

Therefore, the present invention provides an electromagnetic wave absorber including a resistive layer that is advantageous for exhibiting good chemical resistance. The present invention also provides an electromagnetic wave absorber-attached molded article including such an electromagnetic wave absorber.

Solution to Problem

The present invention provides an electromagnetic wave absorber, including:

a dielectric layer;
a resistive layer that is disposed on one principal surface of the dielectric layer, comprises indium oxide as a main component, and has a polycrystalline structure; and
an electrical conductive layer that is disposed on the other principal surface of the dielectric layer and has a sheet resistance lower than a sheet resistance of the resistive layer, wherein
the resistive layer has a sheet resistance of 260 to 500 $\Omega/\square$ and a specific resistance of $5 \times 10^{-4}$ $\Omega \cdot$ cm or more.

The present invention also provides an electromagnetic wave absorber-attached molded article, including:

a molded article; and
the above electromagnetic wave absorber attached to the molded article.

Advantageous Effects of Invention

In the above electromagnetic wave absorber, the resistive layer has good chemical resistance.

BRIEF DESCRIPTION OF DRAWINGS

FIG. 1 is a cross-sectional view showing an example of an electromagnetic wave absorber of the present invention.
FIG. 2 is a cross-sectional view showing an example of an electromagnetic wave absorber-attached molded article of the present invention.

DESCRIPTION OF EMBODIMENTS

Hereinafter, embodiments of the present invention will be described with reference to the drawings. The following description describes examples of the present invention, and the present invention is not limited to the following embodiments.

The present inventors have newly found the following problem in the course of considering application of electromagnetic wave absorbers to anti-collision systems. For example, when an electromagnetic wave absorber is used in an anti-collision system, the electromagnetic wave absorber is installed on a vehicle such as an automobile. A chemical such as a cleaner can be used sometimes for vehicle maintenance. For example, an alkaline solution can be used sometimes to wash vehicles. Thus, electromagnetic wave absorbers installed on vehicles can have contact with such a chemical while the vehicles are being washed. In particular, a resistive layer in a $\lambda/4$ electromagnetic wave absorber tends to be affected by such a chemical because the resistive layer is located near the surface of the electromagnetic wave absorber. This means that if a resistive layer of an electromagnetic wave absorber has good chemical resistance, a high-value added $\lambda/4$ electromagnetic wave absorber can be provided.

When a resistive layer for a $\lambda/4$ electromagnetic wave absorber has a sheet resistance closer to the characteristic impedance of air (about 377 $\Omega/\square$), a good electromagnetic wave absorber is more likely to be obtained. It is conceivable that a material including indium oxide, such as indium tin oxide (ITO), as a main component is used as a resistive layer. ITO is also used in technical fields of, for example, flat panel displays and solar cells. An ITO used in these technical fields serves as a transparent electrode, and thus naturally has a low specific resistance (for example, $4 \times 10^{-4}$ $\Omega \cdot$ cm or less). Therefore, when a resistive layer of a $\lambda/4$ electromagnetic wave absorber is formed using the ITO used in these technical fields, the thickness of the resistive layer needs to be reduced (to less than 15 nm, for example) to impart a desired sheet resistance to the resistive layer. However, reduction in thickness of a resistive layer makes it difficult to achieve good chemical resistance. Moreover, it is difficult to stably manufacture such a thin resistive layer.

The ITO serving as a transparent electrode in technical fields of, for example, flat panel displays and solar cells is often required to have good etching properties because of the need to form circuit patterns. Therefore, an ITO having an amorphous structure is preferably used in these technical fields. However, it is difficult to achieve good chemical resistance by using, as a resistive layer, an ITO having an amorphous structure and preferably used in these technical fields.

Therefore, through intensive studies for a technique capable of achieving good chemical resistance by using, as a resistive layer, a material including indium oxide as a main component, the present inventors have invented an electromagnetic wave absorber according to the present invention.

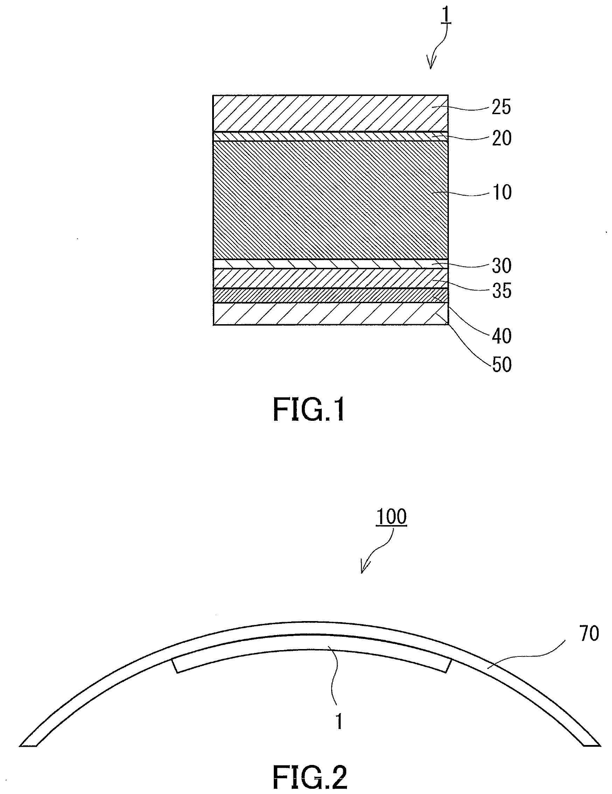

As shown in FIG. 1, an electromagnetic wave absorber 1 includes a dielectric layer 10, a resistive layer 20, and an electrical conductive layer 30. The resistive layer 20 is disposed on one principal surface of the dielectric layer 10, includes indium oxide as a main component, and has a polycrystalline structure. Additionally, the resistive layer 20 has a sheet resistance of 260 to 500 $\Omega/\square$ and a specific resistance of $5 \times 10^{-4}$ $\Omega \cdot$ cm or more. The electrical conductive layer 30 is disposed on the other principal surface of the dielectric layer 10 and has a sheet resistance lower than a sheet resistance of the resistive layer 20. The term "main component" as used herein refers to a component whose content is highest on a weight basis. Typically, the content of the indium oxide in the resistive layer 20 is 50 weight% or more.

The electromagnetic wave absorber 1 is a $\lambda/4$ electromagnetic wave absorber. The $\lambda/4$ electromagnetic wave absorber is designed so that incidence of an electromagnetic wave having a wavelength $(\lambda_O)$ to be absorbed will result in interference between the electromagnetic wave reflected by the surface of the resistive layer 20 (front surface reflection) and the electromagnetic wave reflected by the electrical conductive layer 30 (back surface reflection). In the $\lambda/4$ electromagnetic wave absorber, the wavelength $(\lambda_O)$ of an electromagnetic wave to be absorbed is determined according to the thickness (t) of the dielectric layer 10 and the relative permittivity $(\varepsilon_r)$ of the dielectric layer 10, as shown in the following equation (1). That is, an electromagnetic wave having a wavelength to be absorbed can be set by appropriately adjusting the material and thickness of the dielectric layer 10. In the equation (1), sqrt($\varepsilon_r$) means a square root of the relative permittivity ($\varepsilon_r$).

$$\lambda_O = 4t \times sqrt(\varepsilon_r) \qquad \text{Equation (1)}$$

As the resistive layer 20 has a sheet resistance of 260 to 500 $\Omega/\square$, the resistive layer 20 has a characteristic impedance close to that of air and the electromagnetic wave absorber 1 can exhibit good electromagnetic wave absorption properties. For example, selective absorption of an electromagnetic wave having a wavelength generally employed by a millimeter-wave radar or quasi-millimeter-wave radar is made easy. For example, the electromagnetic wave absorber 1 can effectively attenuate an electromagnetic wave having a frequency of 50 to 100 GHz, particularly 60 to 90 GHz, employed by a millimeter-wave radar. Moreover, as the resistive layer 20 includes indium oxide as a main component and has a polycrystalline structure, the resistive layer 20 is likely to have good chemical resistance. Additionally, as the resistive layer 20 has a specific resistance of $5 \times 10^{-4}$ $\Omega \cdot$ cm or more, even the resistive layer 20 having a thickness greater than a predetermined value can have a sheet resistance of 260 to 500 $\Omega/\square$. As a result, the electromagnetic wave absorber 1 can exhibit good electromagnetic wave absorption properties, and the resistive layer 20 and even the electromagnetic wave absorber 1 have good chemical resistance.

The resistive layer 20 has a specific resistance of, for example, $5 \times 10^{-3}$ $\Omega \cdot$ cm or less. In this case, the resistive layer thickness required to provide the resistive layer 20 with a sheet resistance of 260 to 500 $\Omega/\square$ cannot be too large. This allows the resistive layer 20 to have good chemical resistance and can shorten the time required to form the resistive layer 20.

The resistive layer 20 has a thickness of, for example, 15 to 200 nm. This allows the resistive layer 20 to have good chemical resistance and can shorten the time required to form the resistive layer 20.

The resistive layer 20 may include indium oxide only, or may include a component other than indium oxide. When the resistive layer 20 includes a component other than indium oxide, the resistive layer 20 includes, for example, tin oxide. The content of the tin oxide in the resistive layer 20 is, for example, less than 5 weight%. An ITO containing less than 5 weight% of tin oxide is has a relatively high specific resistance, and the resistive layer 20 including such an ITO has a specific resistance of $5 \times 10^{-4}$ $\Omega \cdot$ cm or more.

The resistive layer 20 may include, for example, tin oxide and an impurity element. In this case, the content of the tin oxide in the resistive layer 20 is 5 weight% or more and less than 13 weight%. Additionally, the content of the impurity element in the resistive layer 20 is lower than the content of the tin oxide on a weight% basis. Even when the content of the tin oxide in the resistive layer 20 is 5 weight% or more and less than 13 weight%, the coexistence of the predetermined impurity element with the tin oxide allows the resistive layer 20 to have a relatively high specific resistance. Consequently, the resistive layer 20 has a specific resistance of $5 \times 10^{-4}$ $\Omega \cdot$ cm or more.

The above impurity element includes, for example, at least one of silicon, magnesium, titanium, and nitrogen. This allows the resistive layer 20 to have a relatively high specific resistance.

The resistive layer 20 can be formed, for example, by performing sputtering using a target material having a given composition and subjecting the resultant film to a heat treatment (annealing treatment). In this case, even when the film formed by the sputtering has an amorphous structure, the resistive layer 20 having a polycrystalline structure can be formed by the heat treatment. It should be noted that by adjusting the sputtering conditions such as a film formation temperature, the resistive layer 20 having a polycrystalline structure can be formed without performing the heat treatment after the sputtering.

As shown in FIG. 1, the resistive layer 20 is, for example, laminated on the polymer film 25 at an opposite surface to a surface at which the resistive layer 20 is in contact with the dielectric layer 10. The polymer film 25 functions as a support of the resistive layer 20. The polymer film 25 is desirably made of a material providing a smooth surface in the case where the resistive layer 20 is produced, for example, by sputtering. Moreover, since the polymer film 25 is disposed to cover the resistive layer 20, the polymer film 25 having high chemical resistance ensures high chemical resistance of the electromagnetic wave absorber 1. Therefore, examples of the material of the polymer film 25 include: polyester resins such as polyethylene terephthalate (PET) and polyethylene naphthalate (PEN); acrylic resins such as polymethyl methacrylate (PMMA); polycarbonate (PC); and cycloolefin polymer (COP). In particular, the material of the support of the resistive layer 20 is desirably PET in terms of the balance among good chemical resistance, the dimensional stability, and cost.

The polymer film 25 has a thickness of, for example, 10 to 150 $\mu$m, desirably 20 to 100 pm, and more desirably 30 to 80 pm. This can decrease the flexural rigidity of the polymer film 25, and can reduce occurrence of a crease or deformation in the case where the resistive layer 20 is formed on the polymer film 25.

The dielectric layer 10 has a relative permittivity of, for example, 1 to 10. This allows the electromagnetic wave absorber 1 to exhibit good electromagnetic wave absorption performance in a wide bandwidth (for example, a bandwidth of 2 GHz or more in the frequency band from 50 to 100 GHz). The relative permittivity of the dielectric layer 10 can be measured, for example, by cavity resonator perturbation.

The dielectric layer 10 may be a single layer, or may be a laminate consisting of a plurality of layers. When the dielectric layer 10 is a laminate consisting of a plurality of layers, the relative permittivity of the dielectric layer 10 can be determined by measuring the respective layers for the relative permittivity, multiplying the obtained relative permittivity values of the respective layers by the proportions of the thicknesses of the respective layers to the thickness of the whole dielectric layer 10, and adding the resultant values.

The material of the dielectric layer 10 is not limited to a particular one, but the dielectric layer 10 is made of, for example, a polymeric material. Examples of the polymeric material of the dielectric layer 10 include synthetic resins (including thermoplastic elastomers) such as acrylic resin, ethylene-vinyl acetate copolymer (EVA), polyvinyl chloride, polyurethane, acrylic urethane resin, polyolefin, polypropylene, polyethylene, silicone resin, polyethylene terephthalate, polyester, polystyrene, polyimide, polycarbonate, polyamide, polysulfone, polyethersulfone, and epoxy resin and synthetic rubbers such as polyisoprene rubber, polystyrene-butadiene rubber, polybutadiene rubber, chloroprene rubber, acrylonitrile-butadiene rubber, butyl rubber, acrylic rubber, ethylene propylene rubber, and silicone rubber. One of these is used alone as the polymeric material of the dielectric layer 10, or a combination of two or more thereof is used as the polymeric material of the dielectric layer 10.

The dielectric layer 10 may be a foam in some cases. This makes it likely that the dielectric layer 10 has a low relative permittivity. Moreover, this can make the dielectric layer 10 lighter. Examples of the foam include olefin foams and polyester foams.

The thickness of the dielectric layer 10 is, for example, 50 to 2000 pm and desirably 100 to 1000 $\mu$m. This makes it easy to achieve both high dimensional accuracy and low cost.

The electrical conductive layer 30 reflects an electromagnetic wave to be absorbed by the electromagnetic wave absorber 1 in the vicinity of the rear surface of the electromagnetic wave absorber. The electrical conductive layer 30 has a sheet resistance of, for example, 0.001 to 30 $\Omega/\square$. This makes it easy for the electromagnetic wave absorber 1 to exhibit desired electromagnetic wave absorption properties. For example, the electromagnetic wave absorber 1 can effectively attenuate an electromagnetic wave having a frequency of 50 to 100 GHz, particularly 60 to 90 GHz, employed by a millimeter-wave radar.

The material of the electrical conductive layer 30 is, for example, (i) a metal such as aluminum, copper, nickel, chromium, or molybdenum, (ii) an alloy of any of these metals, or (iii) ITO. When the material of the electrical conductive layer 30 is ITO, an ITO containing 5 to 15 weight% of tin oxide can be used.

As shown in FIG. 1, the electrical conductive layer 30 may be laminated on the polymer film 35. The polymer film 35 functions as a support supporting the electrical conductive layer 30. In this case, the material of the polymer film 35 may be any one of those mentioned as the examples of the material of the polymer film 25, or may be polyester, polypropylene, polyurethane, urethane acrylic resin, biaxially-oriented polypropylene (CPP), or vinylidene chloride resin. The polymer film 35 can be omitted in some cases.

A certain coating may be provided on a principal surface which is of either the resistive layer 20 or electrical conductive layer 30 and faces the dielectric layer 10. This can prevent the component included in the dielectric layer 10 from spreading to the resistive layer 20 or electrical conductive layer 30 and affecting the properties of the resistive layer 20 or electrical conductive layer 30. Examples of the material of such a coating include silicon oxide such as $SiO_2$, silicon nitride, aluminum oxide such as $Al_2O_3$, aluminum nitride (AlN), niobium oxide such as $Nb_2O_5$, strontium titanate (STO), and aluminum zinc oxide (AZO). In particular, when the material of the coating is AlN or AZO, the durability of the resistive layer 20 or electrical conductive layer 30 can be advantageously enhanced.

As shown in FIG. 1, the electromagnetic wave absorber 1 further includes an adhesive layer 40 and a separator 50. The adhesive layer 40 is disposed on an external side of the electrical conductive layer 30. The separator 50 is disposed in contact with the adhesive layer 40. The electromagnetic wave absorber 1 can be easily attached to an article such as a molded article by peeling off the separator 50 to bare the adhesive layer 40 and pressing the adhesive layer 40 against the article. The adhesive layer 40 can be protected by the separator 50 until the electromagnetic wave absorber 1 is attached to an article.

The adhesive layer 40 includes, for example, a pressure sensitive adhesive such as an acrylic adhesive, a rubber adhesive, a silicone adhesive, or an urethane adhesive.

As shown in FIG. 2, an electromagnetic wave absorber-attached molded article 100, for example, can be produced using the electromagnetic wave absorber 1. The electromagnetic wave absorber-attached molded article 100 includes a molded article 70 and the electromagnetic wave absorber 1 attached to the molded article 70. Examples of the molded article 70 include automotive parts such as a bumper.

An example of a method for producing the electromagnetic wave absorber 1 will be described. The resistive layer 20 is formed on the polymer film 25 by a film formation method such as sputtering. In addition, a laminate in which the electrical conductive layer 30 is formed on the polymer film 35 is prepared.

Next, a resin composition molded to have a predetermined thickness and forming the dielectric layer 10 is put on the electrical conductive layer 30. After that, one principal surface of the resistive layer 20 is placed on the resin composition forming the dielectric layer 10. The resin composition is cured if necessary. The electromagnetic wave absorber 1 can be produced in this manner. According to this method, the thickness of the dielectric layer 10 is controlled easily, and thus the electromagnetic wave absorber 1 can be produced so that the electromagnetic wave absorber 1 can effectively absorb an electromagnetic wave having a wavelength to be absorbed. Moreover, since the resistive layer 20 and electrical conductive layer 30 are formed separately, the time required to produce the electromagnetic wave absorber 1 is short and the production cost of the electromagnetic wave absorber 1 is low. An adhesive or a pressure sensitive adhesive may be used to adhere the dielectric layer 10 and electrical conductive layer 30 or resistive layer 20.

EXAMPLES

Hereinafter, the present invention will be described in more detail by examples. The present invention is not limited to the examples given below. First, methods for measuring the properties of resistive layers according to Examples and Comparative Examples and a method for evaluating samples according to Examples and Comparative Examples will be described.

[X-ray diffraction]

In Examples and Comparative Examples, the thickness was measured for the resistive layers by X-ray reflectivity using an X-ray diffractometer (manufactured by Rigaku Corporation, product name: RINT2200). X-ray diffraction patterns of the resistive layers were also obtained using the X-ray diffractometer. CuKa radiation was used as the X-ray. Whether the resistive layers have a polycrystalline structure or an amorphous structure was confirmed from the obtained X-ray diffraction patterns. The results are shown in Table 1.

[Sheet resistance]

The sheet resistance of the resistive layers according to Examples and Comparative Examples not having undergone a chemical immersion treatment was measured by an eddy current method according to Japanese Industrial Standards (JIS) Z 2316 using a non-contact resistance measurement apparatus (manufactured by NAPSON CORPORATION, product name: NC-80MAP). The results are shown in Table 1. Additionally, the resistive layers having undergone a chemical immersion treatment were also measured for the sheet resistance.

[Specific resistance]

In each of Examples and Comparative Examples, the specific resistance of the resistive layer was determined by calculating a product of the thickness measured as above for the resistive layer and the sheet resistance measured as above for the resistive layer not having undergone a chemical immersion treatment. The results are shown in Table 1.

[Relative permittivity]

The relative permittivity of the dielectric layer according to Example 1 at 10 GHz was measured by cavity resonator perturbation using a network analyzer (manufactured by Agilent Technologies, Inc., product name: N5230C) and cavity resonator (Cavity Resonator CP-531, manufactured by Kanto Electronics Application Development Inc.).

[Electromagnetic wave absorption properties]

The return loss (absolute value of the amount of reflection) was measured according to JIS R 1679:2007 using a 76-GHz millimeter wave perpendicularly incident on respective surfaces of samples A (not having undergone a chemical immersion treatment) and B (having undergone a chemical immersion treatment) according to each of Examples and Comparative Examples. The results are shown in Table 1. Moreover, comprehensive evaluation was performed for Examples and Comparative Examples according to the following measures. The results are shown in Table 1.

a: Both the sample A and sample B have a return loss of 20 dB or more.
b: Either the sample A or sample B or both the sample A and sample B have a return loss of 10 dB or more and less than 20 dB.
x: Either the sample A or sample B or both the sample A and sample B have a return loss of less than 10 dB.

<Example 1>

A film made of amorphous $In_2O_3$ was formed on a 38-$\mu$m-thick PET film (DIAFOIL manufactured by Mitsubishi Chemical Corporation) by a DC magnetron sputtering method using a target material made of $In_2O_3$. The film was subjected to a heat treatment in air at a temperature of 150°C for 3 hours to crystallize the $In_2O_3$. A resistive layer according to Example 1 was formed in this manner. The thickness, sheet resistance, and specific resistance of the resistive layer according to Example 1 are shown in Table 1. A dielectric layer according to Example 1 was produced by press-molding an acrylic resin having a relative permittivity of 2.6 to have a thickness of 560 $\mu$m. As an electrical conductive layer according to Example 1, an aluminum foil having a sheet resistance of 0.002 $\Omega/\square$ was prepared. The resistive layer according to Example 1 not having undergone a chemical immersion treatment was adhered to one principal surface of the dielectric layer according to Example 1 so that the resistive layer according to Example 1 was in contact with the principal surface. Additionally, the electrical conductive layer according to Example 1 was brought into contact with and adhered to the other principal surface of the dielectric layer according to Example 1. A sample A according to Example 1 was produced in this manner.

A resistive layer as formed above in Example 1 was formed on a PET film as used above. A chemical immersion treatment was performed in which the PET film having the resistive layer formed thereon was immersed in a 5 weight% aqueous solution of NaOH for 5 minutes, followed by air drying to produce a resistive layer having undergone the chemical immersion treatment. The temperature of the aqueous NaOH solution used in the chemical immersion treatment was at 40°C. A sample B according to Example 1 was prepared in the same manner as for the sample A, except that the resistive layer having undergone the chemical immersion treatment was used instead of the resistive layer according to Example 1 not having undergone the chemical immersion treatment.

<Examples 2 and 3>

Resistive layers according to Examples 2 and 3 made of $In_2O_3$ were formed in the same manner as in Example 1, except that the sputtering conditions were changed so that the thickness of the resistive layers and the sheet resistance of the resistive layers would be as shown in Table 1. In the formation of the resistive layers according to Examples 2 and 3, the film made of amorphous $In_2O_3$ and obtained by the sputtering was crystallized by a heat treatment performed under the same conditions as in Example 1. Samples A (not having undergone the chemical immersion treatment) and samples B (having undergone the chemical immersion treatment) according to Examples 2 and 3 were produced in the same manner as in Example 1, except that the resistive layer according to Example 2 or 3 was used instead of the resistive layer according to Example 1.

<Example 4>

A resistive layer according to Example 4 made of an ITO including 2.5 weight% of tin oxide was formed in the same manner as in Example 1, except that ITO was used as a target material and the sputtering conditions were changed so that the thickness of the resistive layer and the sheet resistance of the resistive layer would be as shown in Table 1. In the formation of the resistive layer according to Example 4, the amorphous ITO film obtained by the sputtering was crystallized by a heat treatment performed under the same conditions as in Example 1. A sample A (not having undergone the chemical immersion treatment) and sample B (having undergone the chemical immersion treatment) according to Example 4 were produced in the same manner as in Example 1, except that the resistive layer according to Example 4 was used instead of the resistive layer according to Example 1.

<Example 5>

A resistive layer according to Example 5 made of an ITO including 3.3 weight% of tin oxide was formed in the same manner as in Example 1, except that ITO was used as a target material and the sputtering conditions were changed so that the thickness of the resistive layer and the sheet resistance of the resistive layer would be as shown in Table 1. In the formation of the resistive layer according to Example 5, the amorphous ITO film obtained by the sputtering was crystallized by a heat treatment performed under the same conditions as in Example 1. A sample A (not having undergone the chemical immersion treatment) and sample B (having undergone the chemical immersion treatment) according to Example 5 were produced in the same manner as in Example 1, except that the resistive layer according to Example 5 was used instead of the resistive layer according to Example 1.

<Example 6>

A resistive layer according to Example 6 made of a material including 7.5 weight% of $SnO_2$ and 2.5 weight%

of $SiO_2$ in addition to $In_2O_3$ was formed in the same manner as in Example 1, except that a target material including $In_2O_3$, $SnO_2$, and $SiO_2$ was used and the sputtering conditions were changed so that the thickness of the resistive layer and the sheet resistance of the resistive layer would be as shown in Table 1. In the formation of the resistive layer according to Example 6, the amorphous film obtained by the sputtering was crystallized by a heat treatment performed under the same conditions as in Example 1. A sample A (not having undergone the chemical immersion treatment) and sample B (having undergone the chemical immersion treatment) according to Example 6 were produced in the same manner as in Example 1, except that the resistive layer according to Example 6 was used instead of the resistive layer according to Example 1.

<Example 7>

A resistive layer according to Example 7 made of a material including 7.5 weight% of $SnO_2$ and 2.5 weight% of MgO in addition to $In_2O_3$ was formed in the same manner as in Example 1, except that a target material including $In_2O_3$, $SnO_2$, and MgO was used and the sputtering conditions were changed so that the thickness of the resistive layer and the sheet resistance of the resistive layer would be as shown in Table 1. In the formation of the resistive layer according to Example 7, the amorphous film obtained by the sputtering was crystallized by a heat treatment performed under the same conditions as in Example 1. A sample A (not having undergone the chemical immersion treatment) and sample B (having undergone the chemical immersion treatment) according to Example 7 were produced in the same manner as in Example 1, except that the resistive layer according to Example 7 was used instead of the resistive layer according to Example 1.

<Example 8>

A resistive layer according to Example 8 made of a material including 7.5 weight% of $SnO_2$ and 2.5 weight% of $TiO_2$ in addition to $In_2O_3$ was formed in the same manner as in Example 1, except that a target material including $In_2O_3$, $SnO_2$, and $TiO_2$ was used and the sputtering conditions were changed so that the thickness of the resistive layer and the sheet resistance of the resistive layer would be as shown in Table 1. In the formation of the resistive layer according to Example 8, the amorphous film obtained by the sputtering was crystallized by a heat treatment performed under the same conditions as in Example 1. A sample A (not having undergone the chemical immersion treatment) and sample B (having undergone the chemical immersion treatment) according to Example 8 were produced in the same manner as in Example 1, except that the resistive layer according to Example 8 was used instead of the resistive layer according to Example 1.

<Example 9>

A resistive layer according to Example 9 made of a material including 7.5 weight% of $SnO_2$ and 3 atomic% of nitrogen in addition to $In_2O_3$ was formed in the same manner as in Example 1, except that a target material including $In_2O_3$ and $SnO_2$ and a reactive gas including nitrogen gas were used and the sputtering conditions were changed so that the thickness of the resistive layer and the sheet resistance of the resistive layer would be as shown in Table 1. In the formation of the resistive layer according to Example 9, the amorphous film obtained by the sputtering was crystallized by a heat treatment performed under the same conditions as in Example 1. A sample A (not having undergone the chemical immersion treatment) and sample B (having undergone the chemical immersion treatment) according to Example 9 were produced in the same manner as in Example 1, except that the resistive layer according to Example 9 was used instead of the resistive layer according to Example 1.

<Example 10>

A resistive layer according to Example 10 made of a material including 10 weight% of $SnO_2$ and 5 weight% of $SiO_2$ in addition to $In_2O_3$ was formed in the same manner as in Example 1, except that a target material including $In_2O_3$, $SnO_2$, and $SiO_2$ was used and the sputtering conditions were changed so that the thickness of the resistive layer and the sheet resistance of the resistive layer would be as shown in Table 1. In the formation of the resistive layer according to Example 10, the amorphous film obtained by the sputtering was crystallized by a heat treatment performed under the same conditions as in Example 1. A sample A (not having undergone the chemical immersion treatment) and sample B (having undergone the chemical immersion treatment) according to Example 10 were produced in the same manner as in Example 1, except that the resistive layer according to Example 10 was used instead of the resistive layer according to Example 1.

<Example 11>

A film made of amorphous ITO including 10 weight% of tin oxide was formed on a 38-μm-thick PET film (DIAFOIL manufactured by Mitsubishi Chemical Corporation) by a DC magnetron sputtering method. The film was crystallized by a heat treatment in air at a temperature of 150°C for 3 hours. An electrical conductive layer according to Example 11 was formed in this manner. The thickness of the electrical conductive layer according to Example 11 was 120 nm. The sheet resistance of the electrical conductive layer according to Example 11 was 20 Ω/□. A sample A (not having undergone the chemical immersion treatment) and sample B (having undergone the chemical immersion treatment) according to Example 11 were produced in the same manner as in Example 1, except that the electrical conductive layer according to Example 11 was used instead of the electrical conductive layer according to Example 1.

<Comparative Example 1>

A resistive layer according to Comparative Example 1 made of a polycrystalline-structured material including ZnO as a main component and 3 weight% of Ga$_2$O$_3$ was formed on a 38-μm-thick PET film (DIAFOIL manufactured by Mitsubishi Chemical Corporation) using a target material including ZnO and Ga$_2$O$_3$ by a DC magnetron sputtering method, in which the sputtering conditions were adjusted so that the thickness of the resistive layer and sheet resistance of the resistive layer would be as shown in Table 1. In the formation of the resistive layer according to Comparative Example 1, no heat treatment was performed after the sputtering. A sample A (not having undergone the chemical immersion treatment) and sample B (having undergone the chemical immersion treatment) according to Comparative Example 1 were produced in the same manner as in Example 1, except that the resistive layer according to Comparative Example 1 was used instead of the resistive layer according to Example 1.

<Comparative Example 2>

A resistive layer according to Comparative Example 2 made of an amorphous ITO including 10 weight% of tin oxide was formed on a 38-μm-thick PET film (DIAFOIL manufactured by Mitsubishi Chemical Corporation) using ITO as a target material by a DC magnetron sputtering method, in which the sputtering conditions were adjusted so that the thickness and sheet resistance of the resistive layer would be as shown in Table 1. A sample A (not having undergone the chemical immersion treatment) and sample B (having undergone the chemical immersion treatment) according to Comparative Example 2 were produced in the same manner as in Example 1, except that the resistive layer according to Comparative Example 2 was used instead of the resistive layer according to Example 1.

<Comparative Example 3>

A resistive layer according to Comparative Example 3 made of an amorphous ITO including 7.5 weight% of tin oxide was formed in the same manner as in Comparative Example 2, except that ITO was used as a target material and the sputtering conditions were changed so that the thickness of the resistive layer and the sheet resistance of the resistive layer would be as shown in Table 1. A sample A (not having undergone the chemical immersion treatment) and sample B (having undergone the chemical immersion treatment) according to Comparative Example 3 were produced in the same manner as in Example 1, except that the resistive layer according to Comparative Example 3 was used instead of the resistive layer according to Example 1.

<Comparative Example 4>

A resistive layer according to Comparative Example 4 made of an ITO including 2.5 weight% of tin oxide was formed in the same manner as in Example 1, except that ITO was used as a target material and the sputtering conditions were changed so that the thickness of the resistive layer and the sheet resistance of the resistive layer would be as shown in Table 1. In the formation of the resistive layer according to Comparative Example 4, the amorphous ITO film obtained by the sputtering was crystallized by a heat treatment performed under the same conditions as in Example 1. A sample A (not having undergone the chemical immersion treatment) and sample B (having undergone the chemical immersion treatment) according to Comparative Example 4 were produced in the same manner as in Example 1, except that the resistive layer according to Comparative Example 4 was used instead of the resistive layer according to Example 1.

<Comparative Example 5>

A resistive layer according to Comparative Example 5 made of an ITO including 2.5 weight% of tin oxide was formed in the same manner as in Example 1, except that ITO was used as a target material and the sputtering conditions were changed so that the thickness of the resistive layer and the sheet resistance of the resistive layer would be as shown in Table 1. In the formation of the resistive layer according to Comparative Example 5, the amorphous ITO film obtained by the sputtering was crystallized by a heat treatment performed under the same conditions as in Example 1. A sample A (not having undergone the chemical immersion treatment) and sample B (having undergone the chemical immersion treatment) according to Comparative Example 5 were produced in the same manner as in Example 1, except that the resistive layer according to Comparative Example 5 was used instead of the resistive layer according to Example 1.

<Comparative Example 6>

A resistive layer according to Comparative Example 6 made of an ITO including 7.5 weight% of tin oxide was formed in the same manner as in Example 1, except that ITO was used as a target material and the sputtering conditions were changed so that the thickness of the resistive layer and the sheet resistance of the resistive layer would be as shown in Table 1. In the formation of the resistive layer according to Comparative Example 6, the amorphous ITO film obtained by the sputtering was crystallized by a heat treatment performed under the same conditions as in Example 1. A sample A (not having undergone the chemical immersion treatment) and sample B (having undergone the chemical immersion treatment) according to Comparative Example 6 were produced in the same manner as in Example 1, except that the resistive layer according to Comparative Example 6 was used instead of the resistive layer according to Example 1.

<Comparative Example 7>

A resistive layer according to Comparative Example 7 made of a polycrystalline-structured material including ZnO as a main component and 3 weight% of $Al_2O_3$ was formed in the same manner as in Comparative Example 1, except that a target material including ZnO and $Al_2O_3$ was used and the sputtering conditions were changed so that the thickness of the resistive layer and the sheet resistance of the resistive layer would be as shown in Table 1. In the formation of the resistive layer according to Comparative Example 7, no heat treatment was performed after the sputtering. A sample A (not having undergone the chemical immersion treatment) and sample B (having undergone the chemical immersion treatment) according to Comparative Example 7 were produced in the same manner as in Example 1, except that the resistive layer according to Comparative Example 7 was used instead of the resistive layer according to Example 1.

As shown in Table 1, it is suggested that good chemical resistance can be exhibited when the resistive layer has a polycrystalline structure, includes indium oxide as a main component, and has a sheet resistance of 260 to 500 $\Omega/\square$ and a specific resistance of $5 \times 10^{-4}$ $\Omega \cdot$ cm or more.

[Table 1]

| | Resistive layer | | | | | | | | Electrical conductive layer | | Return loss | | Comprehensive judgment |
|---|---|---|---|---|---|---|---|---|---|---|---|---|---|
| | Material | | | Structure | Thickness [nm] | Initial sheet resistance [Ω/□] | Initial specific resistance [× $10^{-4}$ Ω•cm] | Sheet resistance after chemical immersion treatment [Ω/□] | Material | Sheet resistance [Ω/□] | Sample A not having undergone chemical immersion treatment [dB] | Sample B having undergone chemical immersion treatment [dB] | |
| | Main component | Second component | Impurity | | | | | | | | | | |
| Example 1 | $In_2O_3$ | - | | Polycrystalline | 26 | 370 | 9.6 | 379 | Al | 0.002 | 32 | 31 | a |
| Example 2 | $In_2O_3$ | - | | Polycrystalline | 23 | 450 | 10 | 462 | Al | 0.002 | 21 | 20 | a |
| Example 3 | $In_2O_3$ | - | | Polycrystalline | 32 | 295 | 9.4 | 294 | Al | 0.002 | 20 | 20 | a |
| Example 4 | $In_2O_3$ | $SnO_2$ 2.5 weight% | | Polycrystalline | 20 | 390 | 7.8 | 402 | Al | 0.002 | 27 | 25 | a |
| Example 5 | $In_2O_3$ | $SnO_2$ 3.3 weight% | | Polycrystalline | 17 | 342 | 5.8 | 355 | Al | 0.002 | 26 | 28 | a |
| Example 6 | $In_2O_3$ | $SnO_2$ 7.5 weight% | $SiO_2$ 2.5 weight% | Polycrystalline | 22 | 390 | 8.6 | 395 | Al | 0.002 | 27 | 26 | a |
| Example 7 | $In_2O_3$ | $SnO_2$ 7.5 weight% | MgO 2.5 weight% | Polycrystalline | 20 | 360 | 7.2 | 362 | Al | 0.002 | 29 | 29 | a |
| Example 8 | $In_2O_3$ | $SnO_2$ 7.5 weight% | $TiO_2$ 2.5 weight% | Polycrystalline | 28 | 418 | 12 | 428 | Al | 0.002 | 23 | 22 | a |
| Example 9 | $In_2O_3$ | $SnO_2$ 7.5 weight% | Nitrogen 3 atomic% | Polycrystalline | 27 | 354 | 9.6 | 360 | Al | 0.002 | 27 | 28 | a |
| Example 10 | $In_2O_3$ | $SnO_2$ 10 weight% | $SiO_2$ 5 weight% | Polycrystalline | 85 | 430 | 37 | 428 | Al | 0.002 | 22 | 22 | a |
| Example 11 | $In_2O_3$ | - | - | Polycrystalline | 26 | 370 | 9.6 | 379 | ITO | 20 | 30 | 30 | a |
| Comparative Example 1 | ZnO | $Ga_2O_3$ 3 weight% | | Polycrystalline | 72 | 415 | 30 | 2360 | Al | 0.002 | 23 | 1 | x |

EP 3 641 518 A1

| | Resistive layer | | | | | | | | Electrical conductive layer | | Return loss | | Comprehensive judgment |
|---|---|---|---|---|---|---|---|---|---|---|---|---|---|
| | Material | | | Structure | Thickness [nm] | Initial sheet resistance [Ω/□] | Initial specific resistance [× 10⁻⁴ Ω•cm] | Sheet resistance after chemical immersion treatment [Ω/□] | Material | Sheet resistance [Ω/□] | Sample A not having undergone chemical immersion treatment [dB] | Sample B having undergone chemical immersion treatment [dB] | |
| | Main component | Second component | Impurity | | | | | | | | | | |
| Comparative Example 2 | In$_2$O$_3$ | SnO$_2$ 10 weight% | | Amorphous | 27 | 354 | 9.6 | 980 | Al | 0.002 | 28 | 2 | x |
| Comparative Example 3 | In$_2$O$_3$ | SnO$_2$ 7.5 weight% | | Amorphous | 28 | 401 | 11 | 863 | Al | 0.002 | 24 | 3 | x |
| Comparative Example 4 | In$_2$O$_3$ | SnO$_2$ 2.5 weight% | | Polycrystalline | 36 | 195 | 7.0 | 210 | Al | 0.002 | 12 | 13 | b |
| Comparative Example 5 | In$_2$O$_3$ | SnO$_2$ 2.5 weight% | | Polycrystalline | 14 | 679 | 9.5 | 802 | Al | 0.002 | 9 | 6 | x |
| Comparative Example 6 | In$_2$O$_3$ | SnO$_2$ 7.5 weight% | | Polycrystalline | 11 | 412 | 4.5 | 611 | Al | 0.002 | 24 | 11 | b |
| Comparative Example 7 | ZnO | Al$_2$O$_3$ 3 weight% | | Polycrystalline | 145 | 398 | 58 | 1826 | Al | 0.002 | 25 | 1 | x |

EP 3 641 518 A1

12

**Claims**

1. An electromagnetic wave absorber, comprising:

   a dielectric layer;
   a resistive layer that is disposed on one principal surface of the dielectric layer, comprises indium oxide as a main component, and has a polycrystalline structure; and
   an electrical conductive layer that is disposed on the other principal surface of the dielectric layer and has a sheet resistance lower than a sheet resistance of the resistive layer, wherein
   the resistive layer has a sheet resistance of 260 to 500 $\Omega/\square$ and a specific resistance of $5 \times 10^{-4}\,\Omega \cdot$ cm or more.

2. The electromagnetic wave absorber according to claim 1, wherein the resistive layer has a specific resistance of $5 \times 10^{-3}\,\Omega \cdot$ cm or less.

3. The electromagnetic wave absorber according to claim 1 or 2, wherein the resistive layer has a thickness of 15 to 200 nm.

4. The electromagnetic wave absorber according to any one of claims 1 to 3, wherein
   the resistive layer comprises tin oxide, and
   the content of the tin oxide in the resistive layer is less than 5 weight%.

5. The electromagnetic wave absorber according to any one of claims 1 to 3, wherein
   the resistive layer comprises tin oxide and an impurity element,
   the content of the tin oxide in the resistive layer is 5 weight% or more and less than 13 weight%, and
   the content of the impurity element in the resistive layer is lower than the content of the tin oxide on a weight% basis.

6. The electromagnetic wave absorber according to claim 5, wherein the impurity element comprises at least one of silicon, magnesium, titanium, and nitrogen.

7. The electromagnetic wave absorber according to any one of claims 1 to 6, wherein the dielectric layer has a relative permittivity of 1 to 10.

8. The electromagnetic wave absorber according to any one of claims 1 to 7, wherein the electrical conductive layer has a sheet resistance of 0.001 to 30 $\Omega/\square$.

9. The electromagnetic wave absorber according to any one of claims 1 to 8, further comprising:

   an adhesive layer that is disposed on an external side of the electrical conductive layer; and
   a separator that is disposed in contact with the adhesive layer.

10. An electromagnetic wave absorber-attached molded article, comprising:

    a molded article; and
    the electromagnetic wave absorber according to any one of claims 1 to 9 attached to the molded article.

FIG.1

FIG.2

# EP 3 641 518 A1

## INTERNATIONAL SEARCH REPORT

International application No.

PCT/JP2018/012604

### A. CLASSIFICATION OF SUBJECT MATTER

Int.Cl. H05K9/00(2006.01)i, B32B7/02(2006.01)i, B32B9/00(2006.01)i, B32B15/08(2006.01)i

According to International Patent Classification (IPC) or to both national classification and IPC

### B. FIELDS SEARCHED

Minimum documentation searched (classification system followed by classification symbols)

Int.Cl. H05K9/00, B32B7/02, B32B9/00, B32B15/08

| Documentation searched other than minimum documentation to the extent that such documents are included in the fields searched | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 5-114813 A (TDK CORPORATION) 07 May 1993, entire text, fig. 1-12 (Family: none) | 1-10 |
| Y | JP 8-307088 A (C.I.KASEI CO., LTD.) 22 November 1996, paragraphs [0039]-[0045], [0055], [0058], fig. 1, 7 (Family: none) | 1-10 |
| Y | JP 2000-59066 A (MITSUBISHI CHEMICAL CORP.) 25 February 2000, paragraphs [0012]-[0018], [0027] (Family: none) | 1-10 |

☒ Further documents are listed in the continuation of Box C. ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 12 June 2018 (12.06.2018) | 26 June 2018 (26.06.2018) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

15

**INTERNATIONAL SEARCH REPORT**

International application No.

PCT/JP2018/012604

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2009-238416 A (TOPPAN PRINTING CO., LTD.) 15 October 2009, paragraphs [0033]-[0035], [0050] (Family: none) | 1-10 |
| Y | WO 2004/065656 A1 (BRIDGESTONE CORPORATION) 05 August 2004, page 13, lines 1-13, table 2 & US 2006/0003188 A1, paragraphs [0087]-[0088], table 2 & EP 1591554 A1 | 1-10 |
| Y | JP 4-206403 A (NITTO DENKO CORP.) 28 July 1992, page 3, lower right column, lines 13-20, table 1 (Family: none) | 5-6 |
| A | JP 2002-314284 A (THE YOKOHAMA RUBBER CO., LTD.) 25 October 2002 (Family: none) | 1-10 |
| A | JP 10-13082 A (TOSOH CORP.) 16 January 1998 (Family: none) | 1-10 |
| A | JP 2009-71278 A (ASAHI GLASS CO., LTD.) 02 April 2009 (Family: none) | 1-10 |

Form PCT/ISA/210 (continuation of second sheet) (January 2015)

**EP 3 641 518 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003198179 A